# EUROPÄISCHE PATENTSCHRIFT

(11) **EP 0 602 449 B1**
(45) Veröffentlichungstag und Bekanntmachung des Hinweises auf die Patenterteilung: **01.04.1998**
(21) Anmeldenummer: 93119323.9
(22) Anmeldetag: 01.12.1993
(51) Int. Cl.: G06K 7/08, G06K 19/07, G06K 19/067

(54) **IC-Karte**
IC-card
Carte avec IC

(30) Priorität: 18.12.1992 DE 4243108
(43) Veröffentlichungstag der Anmeldung: 22.06.1994
(73) Patentinhaber: TEMIC TELEFUNKEN microelectronic GmbH, 74072 Heilbronn (DE)
(72) Erfinder: Bruhnke, Michael, D-80798 München (DE); Klötzig, Gerold, D-84174 Eching (DE); Klosa, Klaus, D-80337 München (DE); Smith, Stuart, D-81667 München (DE)
(74) Vertreter: Maute, Hans-Jürgen, Dipl.-Ing.

(56) Entgegenhaltungen:
- EP-A- 0 289 136
- EP-A- 0 309 201
- EP-A- 0 369 622
- EP-A- 0 473 569

## Beschreibung

Die Erfindung betrifft Verfahren zum Betreiben einer kontakt- und batterielose Chip-Karte nach dem Oberbegriff des Anspruchs 1. Weiterhin betrifft die Erfindung eine Anordnung zur Durchführung des Verfahrens.

Kontakt- und batterielose Chip-Karten sind z.B. aus Winfried Wigand, "Die Karte mit dem Chip", Siemens Nixdorf Informationssysteme AG, Berlin und München, 1991, S. 34-36 bekannt. Die Energieversorgung erfolgt durch transformatorische Kopplung über ein Wechselfeld mit einem Schreib-Lese-Gerät. Das Wechselfeld wird von dem Schreib-Lese-Gerät erzeugt. Die Datenübertragung von und zu der Chip-Karte erfolgt durch Modulation des Wechselfelds. Ein geeignetes Verfahren ist in der DE 41 07 311 A1 beschreiben. Auf der Chip-Karte wird die Modulation des Wechselfelds beim lesenden Zugriff von einer geschalteten Last bewirkt, die die Antennenspule bedämpft. Als Modulationsart wird eine Amplitudenmodulation verwendet, die mit anderen Modulationsarten kombiniert werden kann.

Die aus der oben aufgeführten Patentanmeldung bekannte Chip-Karte enthält einen Spannungsdetektor zur Detektion von Austastlücken im Wechselfeld. Dem Spannungsdetektor wird die von der Antennenspule erzeugte Spannung zugeführt. Die genaue Funktionsweise des Spannungsdetektor wird dort nicht beschrieben. In Allgemeinen ist jedoch eine Schaltungsanordnung zur Aufbereitung des Analogsignals, wie z.B. Verstärker und Komparator notwendig, um das gewünschte Ausgangssignal zu generieren.

Aus EP-A-0 473 569 ist ebenfalls ein Verfahren zum Betreiben einer kontakt- und batterielosen Chip-Karte bekannt, die von einem Schreib-Lese-Gerät über ein Wechselfeld mit Energie versorgt wird, wobei der bidirektionale Datentransfer durch Modulation des energieübertragenden Wechselfeldes erfolgt. Die Chip-Karte weist eine Antennenspule, eine Eingangsschaltung, die aus dem Spulenstrom die Versorgungsspannung generiert, und einen Spannungsdetektor zum Detektieren von Austastlücken im Wechselfeld auf.

Die bekannten Anordnungen und Verfahren weisen jedoch den Nachteil auf, daß ein hohes Maß an schaltungstechnischen Aufwand getrieben werden muß, damit der Spannungsdetektor auch bei Versorgungsspannungen um ca. 1 Volt zuverlässig arbeitet.

Aufgabe der Erfindung ist es daher ein Verfahren zum Betreiben einer Chip-Karte nach dem Oberbegriff des Anspruchs 1 derart weiterzubilden, daß ein zuverlässiges Erkennen der Austastlücke bei kleinsten Versorgungsspannungen gewährleistet ist. Diese Aufgabe wird durch ein Verfahren mit den Merkmalen des Anspruchs 1 gelöst. Eine weitere Aufgabe der Erfindung besteht in der Angabe eine Chip-Karte zur Durchführung des oben genannten Verfahrens. Diese Aufgabe wird durch eine Chip-Karte mit den Merkmalen des Anspruchs 3 gelöst.

Die vorteilhafte Weiterbildung der Erfindung erfolgt gemäß den Merkmalen der abhängigen Ansprüche.

Eine kontakt- und batterielose Chip-Karte, wie sie der Erfindung zugrunde liegt, wird durch ein von einem externen Schreib-Lese-Gerät erzeugten Wechselfeld mit Energie versorgt. Die Datenübertragung von und zur Chip-Karte erfolgt durch Modulation des energieübertragenden Wechselfelds. Die Chip-Karte 1 weist eine Antennenspule 2 zur Ankopplung an das Wechselfeld auf. Eine Eingangsschaltung 3 generiert aus dem Spulenstrom die Versorgungsspannung VSS-VDD der Chip-Karte 1. Weiterhin weist die Chip-Karte 1 einen Spannungsdetektor 4 zum Erkennen von Austastlücken im energieübertragenden Wechselfeld auf. Gemäß dem Verfahren nach der Erfindung vergleicht der Spannungsdetektor 4 die an den beiden Spulenenden SP1, SP2 anliegenden Spannungen miteinander und liefert dann ein Ausgangssignal RF_OK, wenn beide Spannungen über einen bestimmten Zeitraum hinaus annähernd gleich groß sind.

Durch den direkten Vergleich der beiden Spannungen miteinander werden Pegelanpassung von Vergleichsspannungen an unterschiedliche Empfangsfeldstärken überflüssig.

Eine vorteilhafte Ausgestaltung des Verfahrens sieht vor, daß während des Schreibbetriebs, also dann, wenn über die Feldaustastung des Wechselfelds Daten auf die Chip-Karte geschrieben werden, die Antennenspule 2 konstant bedämpft wird. Die konstante Bedämpfung der Antennenspule 2 führt zu einem Energieverlust über den bedämpfenden Widerstand und ist daher bei Chip-Karten nach dem Stand der Technik im Schreibbetrieb stets vermieden worden. Bei dem erfindungsgemäßen Verfahren führt die Bedämpfung der Antennenspule zu einem schnellen Abfall der Spulenenergie in Austastlücken, wobei die beiden Anschlüsse der Antennenspule SP1, SP2 schnell auf ein gemeinsames Potential gehen.

Damit dieses Potential auch definiert ist, muß ein Spulenanschluß auf einen festen Bezugspegel gelegt werden. Das kann mit einem hochohmigen Widerstand R geschehen, der in der Feldlücken das Signal an einen Spulenende auf VDD zieht. Der Widerstand R ist daher einerseits mit der Antennenspule 2 und andererseits mit dem VDD-Potential der Versorgungsspannug verbunden. Der Widerstand R kann weiterhin von einem Transistor gebildet sein.

Eine vorteilhafte Ausgestaltung des Spannungsdetektors 4 besteht aus einem Logikgatter 7, dessen beide Eingänge je mit einem Ende der Antennenspule 2 verbunden sind und dessen Ausgang anzeigt, ob eine Austastlücke im Wechselfeld vorliegt.

Um eine längere Integrationszeit zu erhalten, ist der Ausgang des Logikgatters 7 über eine Kapazität 8 mit einem Potential der Versorgungsspannung VSS-VDD verbunden.

Das Logikgatter 7 ist vorzugsweise ein NOR-Gatter 7c, an dessen beiden Eingängen jeweils ein Inverter 7a, 7b zur sauberen Umsetzung der Spulenspannungen SP1, SP2 in Logikpegel vorgeschaltet ist.

Der Ausgang des Spannungsdetektors 4 wird von einem Inverter 9 gebildet, der die an der Kapazität 8 auflaufende, integrierte Spannung in ein binäres Ausgangssignal RF_OK wandelt.

Als konstante Dämpfung für die Antennenspule 2 ist ein Widerstand vorgesehen, der einen der beiden Anschlüsse SP1, SP2 der Antennenspule mit einem Bezugspotential der Versorgungsspannung VSS-VDD verbindet.

Im nachfolgenden ist ein Ausführungsbeispiel der Erfindung anhand der Figuren erläutert.

Es zeigen:
- Figur 1:: ein Blockschaltbild der Chip-Karte nach der Erfindung,
- Figur 2:: ein Ausführungsbeispiel des Spannungsdetektors,
- Figur 3:: den Signalverlauf bei Feldaustastung.

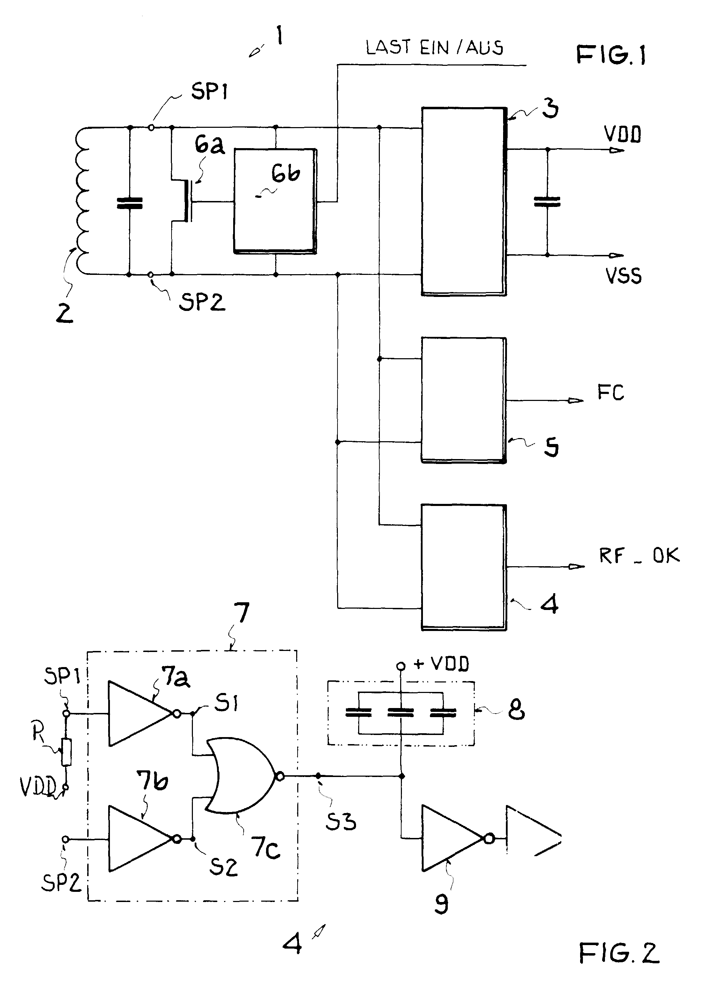

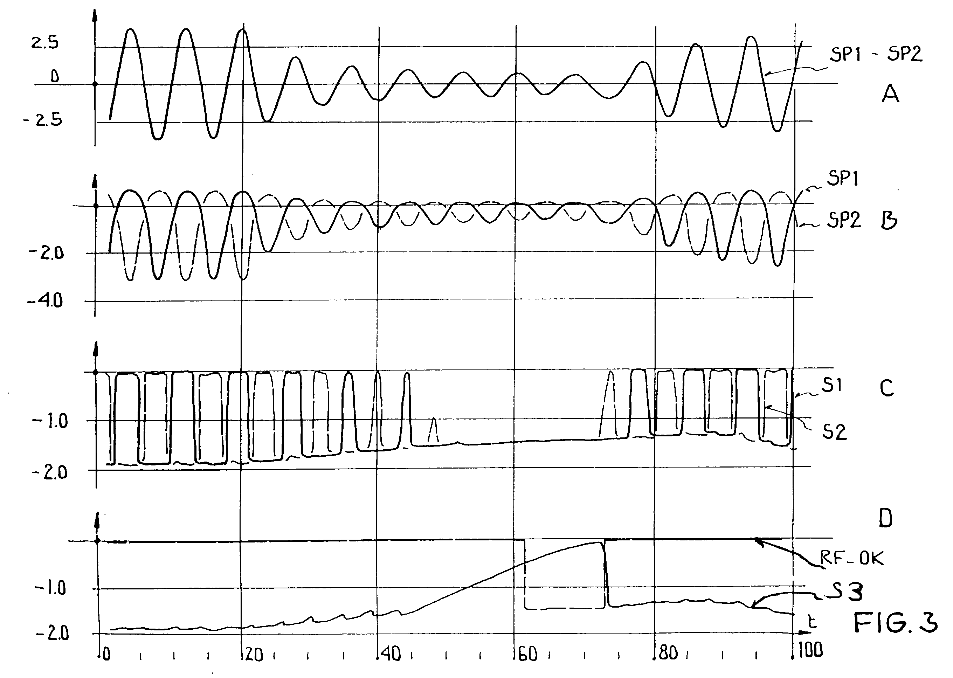

Der Chip-Karte 1 der Figur 1 werden Energie und Daten durch transformatorische Kopplung mit einem nicht dargestellten Schreib-Lese-Gerät über ein von diesem erzeugten Wechselfeld zugeführt. Zum Empfang der Energie und der Daten weist die Chip-Karte eine Antennenspule 2 auf. Sie ist aus verschiedenen Gründen meist nicht in das eigentliche Halbleiterchip der Karte integriert, sondern vielmehr im Kartenkörper angeordnet. Die Antennenspule 2 ist mit der Eingangsschaltung 3 der Chip-Karte 1 verbunden. Die Eingangsschaltung 3 gewinnt aus dem Strom der Antennenspule 2 die Versorgungsspannung VSS-VDD für die Chip-Karte 1. Weiterhin werden von der Eingangsschaltung 3 die über das Wechselfeld übertragenen Daten für die anschließende Weiterverarbeitung aufbereitet. Die weiteren Schaltungsteile des Chip-Karten ICs, wie zum Beispiel EEPROM Speicher, Speicher- und Datenverwaltung, Ausleseschaltungen usw., sind in der Figur der Übersichtlichkeit halber nicht dargestellt.

Die Antennenspule 2 ist weiterhin mit dem Spannungsdetektor 4 und der Takterzeugerschaltung 5 verbunden. Der Feldeffekttransistor 6a besorgt zusammen mit seiner Ansteuerung 6b das Bedämpfen der Antennenspule 2 im Lesebetrieb der Chip-Karte. Beim Schreibbetrieb werden Austastlücken im Wechselfeld, anhand deren die Daten vom Schreib-Lese-Gerät zur Chip-Karte transportiert werden, vom Spannungsdetektor 4 erkannt. An seinem Ausgang liefert er das Signal RF_OK, wenn die an den beiden Spulenanschlüssen SP1, SP2 anliegenden Spannungen Über einen vorgegebenen Zeitraum hinaus annähernd gleich groß sind. Dieser Fall kann nur dann auftreten, wenn in einer Austastlücke des Wechselfeldes die beiden Spulenanschlüsse SP1, SP2 über die Spule kurzgeschlossen sind. Für eine kurze Zeit sind die Spannungen auch beim Nulldurchgang der Spulenspannung gleich groß. Dieser Zustand wird vom Spannungsdetektor 4 jedoch ignoriert.

Die Figur 2 zeigt den Aufbau des Spannungsdetektors 4. Er besteht aus einem NOR-Gatter 7c mit an den Eingängen S1, S2 vorgeschalteten Invertern 7a, 7b. Am Ausgang S3 des NOR-Gatters 7c sorgt eine Kapazität 8 für das Aufsummieren des Ausgangssignals über einen bestimmten Zeitraum. Die Zeitkonstante kann unter anderem über die Größe der Kapazität 8 eingestellt werden. Dies ist in der Figur 2 durch eine Parallelschaltung von drei Kondensatoren 8 angedeutet.

In der Figur 3 A-D ist der Signalverlauf an verschiedenen Schaltungspunkten des Spannungsdetektor 4 gemäß der Figur 2 wiedergegeben. Der im Diagramm A dargestellte Kurvenverlauf entspricht der zwischen den Spulenanschlüssen SP1, SP2 gemessenen Spannung. Auf der horizontalen Achse ist die Zeit in Mikrosekunden aufgetragen. Von der Zeitmarke 20µs an bis zur Zeitmarke 70µs liegt eine Austastlücke im Wechselfeld vor. In diesen Zeitraum nimmt die Amplitude der Spulenspannung SP1-SP2 kontinuierlich ab, da von außen keine Energie mehr zugeführt wird. Die Amplitude der Spulenspannung SP1-SP2 schwingt langsam aus. Nach dem Ende der Austastlücke nimmt die Amplitude zu, bis sie wieder ihren ursprünglichen Wert erreicht hat.

Das Diagramm B zeigt im gleichen zeitlichen Rahmen die Spannungsverläufe an den beiden Anschlüssen der Antennenspule SP1, SP2 gegen das Bezugspotential VDD der Versorgungsspannung VSS-VDD der Chip-Karte gemessen. Die Amplituden der beiden Spannungen nehmen innerhalb der Austastlücke im Wechselfeld ab.

Das Diagramm C zeigt den Signalverlauf an den Eingängen S1, S2 des Logikgatters 7c. Die dem Gatter 7c vorgeschalteten Inverter 7a, 7b wirken als Schwellwertschalter, die das nachgeschaltete Gatter erst dann ansteuern, wenn das Signal am Eingang einen Schwellwert überschritten hat. Das entspricht einer Wandlung eines analogen Signals in ein binäres Signal.

Im Diagramm D ist das Signal am Ausgang S3 des Logikgatters 7 dargestellt. Die mit dem Ausgang verbundene Kapazität 8 bewirkt eine zeitliche Integration des Signals. Erst wenn das Ausgangssignal eine genügend lange Zeit ununterbrochen anliegt, ist die Kapazität 8 genügend aufgeladen, damit der nachgeschaltete Inverter 9 durchschaltet. Ebenfalls im Diagramm D dargestellt ist das Ausgangssignal des Spannungsdetektors RF_OK. Der Inverter 9 wirkt als Schwellwertschalter, der aus dem analogen Signalverlauf an den Kapazitäten (Signal an S3) das logische Signal RF_OK erzeugt.

Liegt nun im Wechselfeld eine Austastlücke vor, so sinken die an den Spulenenden SP1, Sp2 anliegenden Spannungen bezüglich des Bezugspotentials der Versorgungsspannung VSS-VDD ab. Die beiden Inverter 7a, 7b an den Eingängen des NOR-Gatters 7c wirken als Schwellwertschalter, die das ihnen zugeführte analoge Signal digitalisieren und in ein logisches, binäres Signal wandeln. Das nachgeschaltete NOR-Gatter 7c verknüpft die beiden Ausgangssignale S1, S2 der Inverter 7a, 7b. Die am Ausgang des NOR-Gatters 7c liegende Kapazität 8 bewirkt eine Integration über die Zeit. Wenn die Spulenanschlüsse SP1, SP2 für ausreichend lange Zeit annähernd gleich groß sind, steigt die Spannung an der Kapazität 8 so stark an, daß der ebenfalls mit dem Ausgang des NOR-Gatters verbundene Inverter 9 umschaltet.

Am Ende der Austastlücke des Wechselfeld wächst die Spannung an den Anschlüssen der Antennenspule SP1, SP2 wieder an und der Spannungsdetektor 4 wird zurückgesetzt.

Durch geeignetes Dimensionieren des Gatters 7c wird die Verzögerung nur beim Beginn der Austastlücke wirksam. Am Ende dagegen wird der Inverter 9 und damit das Ausgangssignal RF_OK des Spannungsdetektors 4 ohne Verzögerung umgeschaltet.

Durch den beschrieben Spannungsdetektor, der sich durch einfache schaltungstechnische Maßnahmen realisieren läßt, ist ein sicherer Betreib der Chip-Karte möglich. Durch die Verwendung von Standard-Logikelementen zur Verarbeitung eines analogen Signals ist ein Betrieb des Spannungsdetektors in den unteren Bereichen der Versorgungsspannung ohne Probleme möglich.

## Patentansprüche

1. Verfahren zum Betreiben einer kontakt- und batterielosen Chip-Karte (1), die von einem Schreib-Lese-Gerät über ein Wechselfeld mit Energie versorgt wird, wobei der bidirektionale Datentransfer durch Modulation des energieübertragenden Wechselfeldes erfolgt, mit einer Antennenspule (2), einer Eingangsschaltung (3), die aus dem Spulenstrom die Versorgungsspannung (VSS-VDD) generiert und einem Spannungsdetektor (4) zum Detektieren von Austastlücken im Wechselfeld, dadurch gekennzeichnet, daß der Spannungsdetektor (4) die beiden an den Spulenenden anliegenden Spannungen (SP1, SP2) miteinander vergleicht und dann ein Ausgangssignal (RF_OK) liefert, wenn die beiden Spannungen länger als eine vorbestimmte Zeitspanne im wesentlichen gleich groß sind.

2. Verfahren nach Anspruch 1, dadurch gekennzeichnet, daß die Antennenspule (2) während des Schreibbetriebs konstant bedämpft wird.

3. Kontakt- und batterielose Chip-Karte (1), die von einem Schreib-Lese-Gerät über ein Wechselfeld mit Energie versorgt wird, wobei der bidirektionale Datentransfer durch Modulation des energieübertragenden Wechselfeldes erfolgt, mit einer Antennenspule (2), einer Eingangsschaltung (3), die aus dem Spulenstrom die Versorgungsspannung (VDD-VSS) generiert und einem Spannungsdetektor (4) zum Detektieren von Austastlücken im Wechselfeld,
dadurch gekennzeichnet,
daß der Spannungsdetektor (4) eingangsseitig zwei Schwellwertschalter (7a,7b) aufweist, die jeweils mit einem anderen Ende (SP1,SP2) der Antennenspule (2) verbunden sind;
daß ein Logikgatter (7c) die Ausgangssignale (S1,S2) der beiden Schwellwertschalter (7a, 7b) verknüpft und bei deren Gleichheit an seinem Ausgang ein Signal (S3) liefert;
daß eine Kapazität vorgesehen ist, die den Ausgang des Logikgatters (7c) mit einem Potential der Versorgungsspannung (VSS, VDD) verbindet und somit eine Zeitverzögerung des Ausgangssignals (S3) des Logikgatters bewirkt.

4. Chip-Karte nach Anspruch 3, dadurch gekennzeichnet, daß eine Schaltung vorgesehen ist, die ein Ende der Antennenspule (SP1) mit einem definierten Potential verbindet

5. Chip-Karte nach Anspruch 4, dadurch gekennzeichnet, daß das eine Spulenende (SP1) über einen hochohmigen Widerstand (R) mit einem Potential der Versorgungsspannung verbunden ist.

6. Chip-Karte nach Anspruch 5, dadurch gekennzeichnet, daß der hochohmige Widerstand (R) von einem Transistor gebildet wird.

7. Chip-Karte nach einem der Ansprüche 3 - 6, dadurch gekennzeichnet, daß die Schwellwertschalter (7a, 7b) Inverter sind und das Logikgatter (7c) ein NOR-Gatter ist.

8. Chip-Karte nach Anspruch 7, dadurch gekennzeichnet, daß der Ausgang des NOR-Gatters mit dem Eingang eines weiteren Inverters (9) verbunden ist.

## Claims

1. Method of operating a contactless chip card (1) which does not employ a battery and which is supplied with energy from a read-write device via an alternating field, wherein the bidirectional transfer of data occurs by modulating the alternating field conveying the energy and wherein said chip card comprises an antenna coil (2), an input circuit (3) that generates the supply voltage (VSS-VDD) from the current through the coil and a voltage detector (4) for detecting blanking intervals in the alternating field, characterised in that, the voltage detector (4) compares the two voltages (SP1, SP2) present at the ends of the coil with each other and then delivers an output signal (RF-OK) if the two voltages are of substantially the same magnitude for longer than a predetermined period of time.

2. Method in accordance with Claim 1, characterised in that, the antenna coil (2) is constantly subjected to damping during the writing operation.

3. Contactless chip card (1) which does not employ a battery and which is supplied with energy from a read-write device via an alternating field, wherein the bidirectional transfer of data occurs by modulating the alternating field conveying the energy and wherein said chip card comprises an antenna coil (2), an input circuit (3) that generates the supply voltage (VDD-VSS) from the current through the coil and a voltage detector (4) for detecting blanking intervals in the alternating field,
characterised in
that, on its input side, the voltage detector (4) comprises two threshold level switches (7a, 7b) which are respectively connected to a different end (SP1, SP2) of the antenna coil (2);
that a logic gate (7c) logically combines the output signals (S1, S2) from the two threshold level switches (7a, 7b) and delivers a signal (S3) at its output when the signals are equal;
that there is provided a capacitor which connects the output of the logic gate (7c) to a potential of the supply voltage (VSS, VDD) and thus causes a time delay for the output signal (S3) of the logic gate.

4. Chip card in accordance with Claim 3, characterised in that, there is provided a circuit which connects one end of the antenna coil (SP1) to a defined potential.

5. Chip card in accordance with Claim 4, characterised in that, said one end of the coil (SP1) is connected via a high value resistance (R) to a potential of the voltage supply.

6. Chip card in accordance with Claim 5, characterised in that, the high value resistance (R) is formed by a transistor.

7. Chip card in accordance with any of the Claims 3 - 6, characterised in that, the threshold level switches (7a, 7b) are inverters and the logic gate (7c) is a NOR gate.

8. Chip card in accordance with Claim 7, characterised in that, the output of the NOR gate is connected to the input of a further inverter (9).

## Revendications

1. Procédé d'exploitation d'une carte à puce (1) sans contact et sans batterie, qui est alimentée en énergie par un appareil d'écriture-lecture par l'intermédiaire d'un champ alternatif, dans lequel le transfert bidirectionnel des données se fait par modulation du champ alternatif qui transfère l'énergie, comportant une bobine d'antenne (2), un circuit d'entrée (3), qui, à partir du courant de la bobine, génère la tension d'alimentation (VSS-VDD) et un détecteur de tension (4) pour détecter des lacunes apparaissant dans l'exploration du champ alternatif, caractérisé par le fait que le détecteur de tension (4) compare l'une à l'autre les deux tensions (SP1, SP2) obtenues aux extrémités de la bobine et fournit un signal de sortie (RF_OK) lorsque les deux tensions sont sensiblement de même valeur pendant une durée supérieure à une durée prédéterminée.

2. Procédé selon la revendication 1, caractérisé par le fait qu'en mode écriture, la bobine d'antenne (2) est affaiblie de façon constante.

3. Carte à puce (1) sans contact et sans batterie, qui est alimentée en énergie par un appareil d'écriture-lecture par l'intermédiaire d'un champ alternatif, dans lequel le transfert bidirectionnel des données se fait par modulation du champ alternatif qui transfère l'énergie, comportant une bobine d'antenne (2), un circuit d'entrée (3), qui, à partir du courant de la bobine, génère la tension d'alimentation (VSS-VDD) et un détecteur de tension (4) pour détecter des lacunes apparaissant dans l'exploration du champ alternatif,
caractérisée par le fait
que le détecteur de tension (4) présente, du côté de l'entrée, deux interrupteurs à valeur de seuil (7a, 7b) dont chacun est relié à l'une, différente, des extrémités (SP1, SP2) de la bobine d'antenne (2);
qu'une porte logique (7c) relie logiquement les signaux de sortie (S1, S2) des deux interrupteurs à valeur de seuil (7a, 7b) et, en cas d'égalité de ces signaux, fournit à sa sortie un signal (S3);
qu'est prévue une capacité qui relie la sortie de la porte logique (7c) avec un potentiel de la tension d'alimentation (VSS, VDD) et opère donc un retard du signal de sortie (S3) de la porte logique.

4. Carte à puce selon la revendication 3, caractérisée par le fait qu'est prévu un circuit qui relie une extrémité de la bobine d'antenne (SP1) à un potentiel défini.

5. Carte à puce selon la revendication 4, caractérisée par le fait que la première extrémité (SP1) de la bobine est reliée à un potentiel de la tension d'alimentation par l'intermédiaire d'une résistance de valeur élevée (R).

6. Carte à puce selon la revendication 5, caractérisée par le fait que la résistance de valeur élevée (R) est formée par un transistor.

7. Carte à puce selon l'une des revendications 3-6, caractérisée par le fait que les interrupteurs à valeur de seuil (7a, 7b) sont des inverseurs et que la porte logique (7c) est une porte NI.

8. Carte à puce selon la revendication 7, caractérisée par le fait que la sortie de la porte NI est reliée à l'entrée d'un autre inverseur (9).
